(19) **Europäisches Patentamt**
**European Patent Office**
**Office européen des brevets**

(11) **EP 1 305 743 B1**

(12) **EUROPÄISCHE PATENTSCHRIFT**

(45) Veröffentlichungstag und Bekanntmachung des Hinweises auf die Patenterteilung:
**06.10.2010 Patentblatt 2010/40**

(21) Anmeldenummer: **01921205.9**

(22) Anmeldetag: **15.03.2001**

(51) Int Cl.:
*G06F 17/50* *(2006.01)*

(86) Internationale Anmeldenummer:
**PCT/DE2001/000996**

(87) Internationale Veröffentlichungsnummer:
**WO 2001/073617 (04.10.2001 Gazette 2001/40)**

(54) **VERFAHREN ZUR FLÄCHENOPTIMIERUNG VON BAUELEMENTEN IN INTEGRIERTEN SCHALTUNGEN**

METHOD FOR THE SURFACE OPTIMISATION OF COMPONENTS IN INTEGRATED CIRCUITS

PROCEDE D'OPTIMISATION DE SURFACE DE COMPOSANTS DANS DES CIRCUITS INTEGRES

(84) Benannte Vertragsstaaten:
**DE FR GB**

(30) Priorität: **16.03.2000 DE 10012876**

(43) Veröffentlichungstag der Anmeldung:
**02.05.2003 Patentblatt 2003/18**

(73) Patentinhaber: **Infineon Technologies AG**
**85579 Neubiberg (DE)**

(72) Erfinder:
• **BREDERLOW, Ralf**
**81827 München (DE)**
• **PAULUS, Christian**
**82362 Weilheim (DE)**

(74) Vertreter: **Viering, Jentschura & Partner**
**Postfach 22 14 43**
**80504 München (DE)**

(56) Entgegenhaltungen:
• MICHAEL C ET AL: "A flexible statistical model for CAD of submicrometer analog CMOS integrated circuits" IEEE/ACM INTERNATIONAL CONFERENCE ON COMPUTER AIDED DESIGN. DIGEST OF TECHNICAL PAPERS (ICCAD). SANTA CLARA, NOV. 7 - 11, 1993, LOS ALAMITOS, IEEE. COMP. SOC. PRESS, US, Bd. CONF. 11, 7. November 1993 (1993-11-07), Seiten 330-333, XP010216517 ISBN: 0-8186-4490-7

• THEWES R ET AL: "Explanation and quantitative model for the matching behaviour of poly-silicon resistors" ELECTRON DEVICES MEETING, 1998. IEDM '98 TECHNICAL DIGEST., INTERNATIONAL SAN FRANCISCO, CA, USA 6-9 DEC. 1998, PISCATAWAY, NJ, USA,IEEE, US, 6. Dezember 1998 (1998-12-06), Seiten 771-774, XP010321643 ISBN: 0-7803-4774-9

• TO H-Y ET AL: "A NOVEL SENSITIVITY ANALYSIS TECHNIQUE FOR VLSI STATISTICAL DESIGN" 1996 IEEE INTERNATIONAL SYMPOSIUM ON CIRCUITS AND SYSTEMS (ISCAS). CIRCUITS AND SYSTEMS CONNECTING THE WORLD. ATLANTA, MAY 12 - 15, 1996, IEEE INTERNATIONAL SYMPOSIUM ON CIRCUITS AND SYSTEMS (ISCAS), NEW YORK, IEEE, US, Bd. 4, 12. Mai 1996 (1996-05-12), Seiten 485-487, XP000704642 ISBN: 0-7803-3074-9

• RODRIGUEZ-MACIAS R ET AL: "A TOOL FOR FAST MISMATCH ANALYSIS OF ANALOG CIRCUITS" 1995 IEEE INTERNATIONAL SYMPOSIUM ON CIRCUITS AND SYSTEMS (ISCAS). SEATTLE, APR. 30 - MAY 3, 1995, INTERNATIONAL SYMPOSIUM ON CIRCUITS AND SYSTEMS (ISCAS), NEW YORK, IEEE, US, Bd. 3, 30. April 1995 (1995-04-30), Seiten 2148-2151, XP000559119 ISBN: 0-7803-2571-0

- PAULUS C ET AL: "Area optimization of analog circuits considering matching constraints" PROCEEDINGS DESIGN, AUTOMATION AND TEST IN EUROPE CONFERENCE AND EXHIBITION 2000 (CAT. NO. PR00537), PROCEEDINGS OF MEETING ON DESIGN AUTOMATION AND TEST IN EUROPE, PARIS, FRANCE, 27-30 MARCH 2000, Seite 738 XP010377548 2000, Los Alamitos, CA, USA, IEEE Comput. Soc, USA ISBN: 0-7695-0537-6

**Beschreibung**

Die vorliegende Erfindung betrifft ein Verfahren zur Flächenoptimierung von Bauelementen in integrierten Analogschaltungen unter Berücksichtigung der Nebenbedingung einer nicht zu überschreitenden Variation der Ausgangssignale der Schaltungen.

Häufig werden integrierte Schaltungen oder Teilschaltungen oder einzelne Bauteile in solchen Schaltungen implementiert, die bestimmte Schwankungen ihrer Ausgangssignale nicht überschreiten dürfen. So werden Schaltungen in Paaren oder Gruppen identischen Aufbaus verwendet, welche beispielsweise die gleiche Funktion gegenüber unterschiedlichen Signalen etc. übernehmen sollen. Jedoch weisen solche Schaltungen beziehungsweise Bauteile in integrierten Schaltungen auf Grund von statistischen Effekten Abweichungen in ihren elektrischen Parametern auf. Diese Variationen, der sogenannte Device Mismatch auf Grund der Schwankungen von Bauteilparametern, stellt eine wichtige Randbedingung bei der Dimensionierung entsprechender integrierter Schaltungen dar. Der Device Mismatch kann für die verschiedenen Bauelemente in den jeweiligen Herstellungsprozessen integrierter Schaltungen meßtechnisch erfaßt werden und dient als Grundlage bei der Dimensionierung hochgenauer integrierter Schaltungen, beispielsweise von Baugruppen in Analog-Digital- und Digital-Analogwandlern. Es ist bekannt, daß der statistische Mismatch integrierter Schaltungen beziehungsweise Bauteile in ihren elektrischen Parametern mit zunehmender Fläche A abnimmt, wobei sich für die meisten Bauteile ein $1/\sqrt{A}$-Gesetz für die Standardabweichung der relevanten elektrischen Parameter ableiten und experimentell bestätigen läßt. Neben diesen statischen Parameterabweichungen kommen auch dynamische Abweichungen der elektrischen Bauteilparameter vor, die als 1/f Rauschsignal eines Bauteils beobachtet werden können und die eine Abhängigkeit vom Verhältnis von den am Leitungsprozeß beteiligten Ladungsträgern und der Zahl der im Bereich des Stromflusses vorhandenen Störstellen zeigen. Damit ist das 1/f-Rauschen ebenfalls von der aktiven Bauteilfläche abhängig und nimmt mit zunehmender Bauteilfläche ab.

Wird bei einer komplexen analogen Schaltung eine obere Grenze für parametervariationsbedingter Signalfehler am Ausgang der Schaltung gefordert, so müssen die Flächen der verwendeten Bauelemente entsprechend dimensioniert werden. Üblicherweise wird eine Schaltung unter Zuhilfenahme eines Simulationsprogramms entsprechend den Anforderungen entwickelt. Zur Berücksichtigung von Parametervariationseffekten werden in einer Monte-Carlo-Simulationsmethode die elektrischen Parameter der Einzelbauelemente voneinander statistisch unabhängig innerhalb einer vorzugebenden Schwankungsbreite geringfügig verändert, woraufhin erneut eine Simulation durchgeführt und die Abweichung des Ausgangssignals vom Sollwert ermittelt wird. Diese Methodik erweist sich als außerordentlich rechenintensiv, da zur Ermittlung eines einzelnen Punkts im Ergebnisraum die gesamte Schaltung simuliert werden muß. Um statistisch relevante Aussagen treffen zu können, ist eine große Anzahl von Simulationen notwendig. Von den so ermittelten, maximal zulässigen Schwankungsbreiten der elektrischen Parameter kann auf die Mindestfläche der einzelnen Bauteile geschlossen werden, welche sich aus der Simulation ergibt und die zum Erreichen der gewünschten Gesamtgenauigkeit der Schaltung erforderlich ist.

Im folgenden sollen verschiedene Parameterabweichungen kurz vorgestellt werden.

Bei integrierten MOS-Transistoren hängt der Unterschied ihrer Schwellenspannungen im wesentlichen von der Anzahl der in den Kanal implantierten Dotieratome ab. Die Anzahl der Dotieratome nimmt linear mit der Fläche des Transistors zu, so daß sich beispielsweise für die Abweichung seiner Schwellenspannung $V_t$ folgender Zusammenhang zur Bauteilfläche A herstellen läßt:

$$\sigma_{V_t} = \frac{1}{\sqrt{A}} c_{V_t}$$

Auch die Steilheit eines MOS-Transistors unterliegt statistischen Schwankungen. Auch die Abweichung der Steilheit ist proportional zu $1/\sqrt{A}$.

Der Flächenwiderstandswert eines Polysiliziumwiderstands wird im wesentlichen durch den Ladungsträgertransport über die Korngrenzen im Polysilizium bestimmt. Da die mittlere Korngröße und der mittlere Übergangswiderstand zwischen den Körnern einen festen, prozeßspezifischen Wert aufweist läßt sich für Abweichungen des Flächenwiderstandswerts folgende Gegebenheit aufstellen:

$$\sigma_{\Delta R / R} = \frac{1}{\sqrt{A}} c_{\Delta R / R}$$

Auch für dynamische Abweichungen der elektrischen Bauteilparameter, die als 1/f-Rauschsignal eines Bauteils beobachtet werden können, ergibt sich eine Abhängigkeit vom Verhältnis von den am Leitungsprozeß beteiligten Ladungsträgern und der Zahl der im Bereich des Stromflusses vorhandenen Störstellen. Somit ist auch das 1/f-Rauschen von der aktiven Bauteilfläche abhängig und kann modellhaft beschrieben werden als

$$\sigma_{Vg,noise} = V_{g,noise}^{rms} = \sqrt{\int_{f_l}^{f_u} S_{V_g} df} = \sqrt{\frac{K_F}{C_{ox}^2 A} \ln \frac{f_u}{f_l}}$$

Hierbei ist $V_{g,noise,pp}$ das $1\sigma$-Rauschen der äquivalenten Gate-Spannung, $K_F$ die Rauschkonstante, $C_{OX}$ ist die Flächenkapazität des Gateoxids, A die Transistorfläche und $f_u$ und $f_l$ die obere- beziehungsweise untere Grenze des betrachteten Frequenzintervalls. Damit ergibt für die auf den Eingang des Transistors bezogene mittlere Rauschamplitude $S_{V_g}$ folgender Zusammenhang:

$$\sqrt{S_{V_g} \Delta f} = \sigma_{V_{g,noise}} = \frac{c_{V_{g,noise}}}{\sqrt{A}}$$

In allen obigen Formeln ist ein Proportionalitätsfaktor c angegeben worden, der von den betrachteten Bauelementen abhängt. Dieser Proportionalitätsfaktor wird als Matching-Konstante $c_{ij}$ eines betrachteten Bauelements i bezeichnet, wobei j ein Index für den gerade betrachteten elektrischen Parameter ausgewählt aus einer Gruppe von n für das betrachtete Bauelement maßgeblichen oder als maßgeblich betrachteten elektrischen Parameter, welche Variationen unterliegen können, ist.

Die experimentelle Ermittlung der Matching-Konstante wird durch Messung der elektrischen Eigenschaften zweier eng benachbarter Bauteile unter optimalen Layout-Bedingungen ermittelt. Hierzu zählen Kreuzkopplung, das Sicherstellen identischer Umgebungen für die zu matchenden Bauelemente, sowie die Vermeidung von Metallflächen über aktiven Gebieten. Üblicherweise wird das Meßergebnis als Konstante für ein paarweises Vorkommen von Bauelementen angegeben. Tabelle 1 zeigt experimentell bestimmte Matching-Konstanten verschiedener Bauteile für unterschiedliche Parameter, wobei von einer paarweisen Auswertung ausgegangen wird.

Tabelle 1: Experimentell ermittelte Matching-Konstanten von Widerständen und Transistoren in verschiedenen CMOS-Prozessen bei paarweiser Auswertung. Lmin ist die minimale Gatelänge eines Transistors, der mit dem jeweiligen Prozeß hergestellt werden kann.

| $L_{min}$ = 0,5 $\mu$m | | $L_{min}$ = 0.65 $\mu$m | |
|---|---|---|---|
| Bauteil | Matching-Konstante | Bauteil | Matching-Konstante |
| Poly-Si-R | $c_{\Delta R/R}$ = 11 %$\mu$m | Poly-Si-1-R | $c_{\Delta R/R}$ = 12 %$\mu$m |
| n-Diffusion-R | $c_{\Delta R/R}$ = 1.3 %$\mu$m | Poly-Si-2-R | $c_{\Delta R/R}$ = 5.6 %$\mu$m |
| p-Diffusion-R | $c_{\Delta R/R}$ = 1.4 %$\mu$m | Hi-Res-Poly-Si-R | $c_{\Delta R/R}$ = 3.7 %$\mu$m |
| n-MOSFET | $c_{\Delta Vg,n}$ = 16 mV$\mu$m | n-MOSFET | $c_{\Delta Vg,n}$ = 20 mV$\mu$m |
| p-MOSFET | $c_{\Delta Vg,p}$ = 15 mV$\mu$m | P-MOSFET | $c_{\Delta Vg,p}$ = 18 mV$\mu$m |
| $L_{min}$ =0.35 $\mu$m | | $L_{min}$ = 0.25 $\mu$m | |
| Bauteil | Matching-Konstante | Bauteil | Matching-Konstante |
| n-MOSFET | $c_{\Delta Vg,n}$ = 8 mV$\mu$m | n-Poly-Si-R | $c_{\Delta R/R}$ = 4.7 %$\mu$m |
| p-MOSFET | $c_{\Delta Vg,p}$ = 8 mV$\mu$m | p-Poly-Si-R | $c_{\Delta R/R}$ = 3.0 %$\mu$m |
| | | n-MOSFET | $c_{\Delta Vg,n}$ = 8 mV$\mu$m |
| | | | |

Weiterhin sind Verfahren zur Flächenoptimierung von Bauelementen in integrierten Schaltungen unter Verwendung numerischer Verfahren aus (H. Su et al, Statistical constrained optimization of analog MOS circuits using empirical performance models, IEEE International Symposium on Circuits and Systems, Vol. 1, S. 133 - 136, 1994; C.J. Abel et al, Characterization of transistor mismatch for statistical CAD of submicron CMOS analog circuits, IEEE International Symposium on Circuits and Systems, S. 1401 - 1404, 1993; M.J.M. Pelgrom, Matching properties of MOS transistors, IEEE Journal of Solid-State Circuits, Vol. 24, Nr. 5, S. 1433 - 1440, 1989) bekannt.

Somit besteht ein Bedarf, ein weniger iteratives Verfahren zur Bestimmung optimierter Bauelementflächen zu entwickeln. Diese Aufgabe löst die Erfindung durch die Bereitstellung eines Verfahrens zur Flächenoptimierung von Bauelementen bei gepaarten Schaltungen gemäß dem unabhängigen Patentanspruch 1. Weitere vorteilhafte Ausgestaltungen, Details und Aspekte der Erfindung ergeben sich aus den abhängigen Patentansprüchen, der Beschreibung und den beigefügten Zeichnungen.

Der sogenannte Lagrangeformalismus erlaubt eine Extremwertbestimmung unter Nebenbedingungen. Überraschenderweise hat sich gezeigt, daß dieses Lagrange-Gleichungssystem auf Grund des spezifischen Aufbaus der zur Berechnung der Varianz verwendeten Formeln und der vorliegenden Bedingungen für die Gesamtflächenminimierung im vorliegenden Fall analytisch lösbar ist und zur Berechnung der Optima der Bauteilflächen die Verwendung einer einzelnen Gleichung gestattet.

Mit Hilfe des Langrange-Formalismus, der eine Extremwertbestimmung unter Nebenbedingungen erlaubt, kann das zuvor beschriebene Optimierungsproblem analytisch behandelt werden. Die Summe aller Bauteilflächen stellt die zu optimierende Größe dar, die minimal sein soll, um die Chipkosten zu senken. Jedoch dürfen die statistischen Schwankungen der Bauteilparameter nicht zu groß werden. Dies repräsentiert die Nebenbedingung in dem Optimierungsverfahren.

Die Erfindung ist daher gerichtet auf ein Verfahren zur Flächenoptimierung von Bauelementen in einer integrierten Schaltung mit m Bauelementen gemäß Anspruch 1.

Unter einer Schaltung ist hier zumindest eine Schaltungsanordnung zu verstehen, welche bei gleichen Eingangssignalen möglichst identische Ausgangssignale liefern soll. Die Wiederholgenauigkeit oder Standardabweichung $\sigma_{out}$ ist hierbei die Standardabweichung des Ausgangssignals $S_{out}$ der Schaltung, wenn man eine große Anzahl solcher identisch geplanter Schaltungen betrachtet. Die Schaltung weist m Bauelemente auf, wobei m zumindest 1 sein muß. Jedes der Bauelemente der Schaltung weist hierbei elektrische Parameter auf, welche Schwankungen unterliegen können. Von diesen elektrischen Parametern eines i-ten Bauelements werden für die Gleichung n Parameter berücksichtigt. Die Auswahl der berücksichtigten elektrischen Parameter hängt dabei von der gewünschten Genauigkeit der Berechnung der zur Verfügung stehenden Daten bezüglich der Matching-Konstanten und von Abschätzungen bezüglich der Einflußgröße der elektrischen Parameter eines i-ten Bauelements ab. Hierbei ist klar, daß nicht alle Bauelemente die gleiche Zahl von berücksichtigten elektrischen Parametern aufweisen müssen. Die partielle Ableitung des Ausgangssignals $S_{out}$ kennzeichnet hierbei, wie stark sich bei einer kleinen Variation eines elektrischen Parameters das Ausgangssignal verändert.

Das erfindungsgemäße Verfahren muß auf Grund seiner Komplexität automatisiert durchgeführt werden, das heißt in einer Datenverarbeitungsanlage ausgeführt werden. Hierbei können wahlweise digitale Datenverarbeitungsanlagen oder auch entsprechend eingerichtete Analogrechner verwendet werden. Die Datenverarbeitungsanlage kann Teil einer Produktionsstätte für Halbleiter beziehungsweise einer Planungseinheit bei der Halbleiterherstellung sein. Beispielsweise wird es bevorzugt, daß das erfindungsgemäße Verfahren in einem Gerät zur Erzeugung und/oder Planung von Belichtungsmasken für integrierte Halbleiterstrukturen durchgeführt wird.

Das Verfahren kann weiterhin den weiteren Schritt aufweisen: -Synthetisieren eines Schaltplanlayouts an Hand der Flächendaten der Bauelemente.

Hierbei versteht es sich, daß weitere Daten wie beispielsweise der Schaltplan etc. in das Synthetisieren eines Schaltplanlayouts einfließen müssen. Hierbei können entsprechende Simulationsprogramme, die um das erfindungsgemäße Verfahren ergänzt werden, beispielsweise SPICE-basierend, verwendet werden.

Verschiedene elektrische Parameter können Berücksichtigung finden. So kann beispielsweise für ein Bauelement, das ein MOS-Transistor ist, einer der betrachteten elektrischen Parameter die Schwellenspannung dieses Transistors sein. Bei Bauelementen, die integrierte Widerstände sind, kann einer ihrer elektrischen Parameter der Flächenwiderstandswert sein. Bei Vorkommen eines MOS-Transistors kann einer der elektrischen Parameter das 1/f-Rauschsignal sein, ebenso wie bei einem integrierten Widerstand. Das erfindungsgemäße Verfahren funktioniert besonders gut, wenn die einzelnen Parameter $p_{ij}$ voneinander statistisch unabhängig sind.

Das erfindungsgemäße Verfahren kann auch hierarchisch verwendet werden. Ein auf einer bestimmten Hierarchiestufe betrachtetes Bauelement, welches in das erfindungsgemäße Verfahren, wie oben angegeben einfließt, kann wiederum für sich betrachtet eine Schaltung mit mehreren Bauelementen sein. Auf Grund der mathematischen Gegebenheiten des erfindungsgemäßen Verfahrens ist es dann möglich, eine Matching-Konstante $c_{tot}$ für die Gesamtheit dieser Bauelemente (die eine Schaltung bilden), die in ihrer Gesamtheit auf der höheren Hierarchieebene wiederum als Bauelement betrachtet wird, anzugeben, welche sich berechnet nach

$$c_{tot} = \sum_{i=1}^{m} \sqrt{\sum_{j=1}^{n} \left( \frac{\partial S_{out}}{\partial p_{ij}} \right)^2 c_{ij}^2}$$

In manchen Fällen führt eine konsequente Minimierung der Gesamtfläche der Schaltung zu eventuell unerwünschten Flächenverteilungen innerhalb der Schaltung. So kann beispielsweise ein differentielles Paar eine überhöhte Eingangskapazität aufweisen. Als zusätzliche einfache Nebenbedingung kann deshalb die Fläche eines oder mehrerer Bauelemente festgelegt werden und mit den verbleibenden Parametern die Optimierung durchgeführt werden. Die Bestimmung der Mindestflächen $A_i$ der übrigen Bauelemente erfolgt daher so, daß die Bauelemente mit vorgegebener Fläche nicht mit einbezogen werden, wobei die Mindestfläche $A_i$ eines i-ten Bauelementes jeder der gepaarten Schaltungen nach folgender Gleichung bestimmt wird:

$$A_i = \frac{\sum_{i=1}^{k} \sqrt{\sum_{j=1}^{n} \frac{\partial S_{out}}{\partial p_{ij}}^2 c_{ij}^2}}{\hat{\sigma}_{out}^2} \sqrt{\sum_{j=1}^{n} \frac{\partial S_{out}}{\partial p_{ij}}^2 c_{ij}^2}$$

wobei sich $\hat{\sigma}_{out}^2$ ergibt aus der Subtraktion der Fehlerbeträge der festgelegten Bauelemente k+1 bis m zur Gesamtvarianz des Ausgangssignals der Schaltung von der Gesamtvarianz des Ausgangssignals der Schaltung.

Häufig wird es vorkommen, daß lediglich ein elektrischer Parameter für ein bestimmtes Bauelement von Relevanz ist. In diesem Falle kann das Verfahren so durchgeführt werden, daß die Berechnung nach der vereinfachten Gleichung:

$$A_i = \frac{\sum_{i=1}^{m} \left| \frac{\partial S_{out}}{\partial p_i} \right| c_i}{\sigma_{out}^2} \left| \frac{\partial S_{out}}{\partial p_i} \right| c_i$$

erfolgt.

Im folgenden soll die Erfindung weiter erläutert und an konkreten Ausführungsbeispielen dargelegt werden, wobei auf die beigefügten Zeichnungen Bezug genommen werden soll, in denen folgendes dargestellt ist:

Figur 1 zeigt die graphische Wiedergabe des Verfahrens zur Flächenminimierung mit zwei Optimierungparametern;
Figur 2 zeigt den Schaltplan eines beispielhaft betrachteten differentiellen Paars;
Figur 3 zeigt den optimierten Flächenbedarf des differentiellen Paars;
Figur 4 zeigt als Schaltplan eine Stromquelle;
Figur 5 zeigt die optimierten Flächen dieser Stromquelle.

Im folgenden soll eine mathematische Herleitung der im erfindungsgemäßen Verfahren verwendeten Gleichung dargestellt werden.

Eine beliebige analoge Schaltung liefert an ihrem Ausgang ein Ausgangssignal $S_{out}$, das sich aus der sogenannten Übertragungsfunktion ergibt:

$$S_{out}(p_{11}, \ldots p_{mn}) = f(S_{in}, p_{11}, \ldots, p_{mn})$$

wobei, wie oben beschrieben, die Zeichen "p" jeweils n elektrische Parameter der m in der Schaltung verwendeten Bauelemente darstellen. Die konkrete Übertragungsfunktion für eine bestimmte Schaltung muß jeweils bestimmt werden.

Ziel des hier vorgestellten Verfahrens soll die eindeutige Bestimmung der Mindestflächen aller Einzelkomponenten einer komplexen Schaltung sein, so daß ein vorgegebener mismatchbedingter Gesamtfehler nicht überschritten wird. Der geforderte maximale Gesamtfehler der Schaltung stellt die Nebenbedingung in einem Extremwertproblem dar, bei dem beispielsweise das Minimum der notwendigen Gesamtfläche bestimmt wird. Das Gesamtproblem gliedert sich somit in die Bestimmung einer Funktion zur Berechnung einer Gesamtfläche sowie einer Nebenbedingung, nämlich dem Einhalten einer bestimmten Schwankungsbreite (Standardabweichung) des Ausgangssignals. Bei fest vorgegebener Standardabweichung für das Ausgangssignal der Gesamtschaltung soll also deren Fläche minimiert werden. Die Funktion für die Bestimmung der Gesamtfläche lautet somit:

$$f(A_1,...,A_m) = \sum_{i=1}^{m} A_i = A_{tot} \qquad [1]$$

Zur Festlegung der Nebenbedingung muß nunmehr die Berechnung der Standardabweichung bestimmt werden. Wenn die Parameter $p_{ij}$, wobei i ein Index für das Bauteil ausgewählt aus m Bauteilen und j ein Index für den Parameter, ausgewählt aus n möglichen Parametern ist, statistisch unabhängig sind, kann nach den Gesetzen der Fehlerfortpflanzung die Varianz $\sigma_{out}$ des Ausgangssignals $S_{out}$ in einer linearen Näherung wie folgt abgeschätzt werden:

$$\sigma_{out}^2 = \sum_{i=1}^{m} \sum_{j=1}^{n} \left( \frac{\partial S_{out}}{\partial p_{ij}} \right)^2 \sigma_{p_{ij}}^2 \qquad [2]$$

Für den Fehler des Ausgangssignals folgt damit unter Berücksichtigung der oben beschriebenen Flächen- und Matching-Konstanten-abhängigen Variationen:

$$\sigma_{out}^2 = \sum_{i=1}^{m} \sum_{j=1}^{n} \left( \frac{\partial S_{out}}{\partial p_{ij}} \right)^2 \frac{c_{ij}^2}{A_i} \qquad [3]$$

Diese Beziehung ist der Ausgangspunkt für die weiteren Berechnungen, die eine Optimierung einer beliebigen analogen Schaltung hinsichtlich verschiedener flächenabhängiger Randbedingungen ermöglichen. Die Nebenbedingung φ(A1, ..., Am) ergibt sich nunmehr aus Gleichung 3 zu:

$$\varphi(A_1,...,A_m) = \sigma_{out}^2 - \sum_{i=1}^{m} \sum_{j=1}^{n} \left( \frac{\partial S_{out}}{\partial p_{ij}} \right)^2 \frac{c_{ij}^2}{A_i} = 0 \qquad [4]$$

Nunmehr kann die Lagrangefunktion L dieses Extremwertproblems bestimmt werden. Der Lagrangeformalismus ist eine dem Fachmann geläufige Methodik zur Extremwertbestimmung unter Nebenbedingungen. Die sich ergebende Lagrangefunktion L ist:

$$L = \sum_{i=1}^{m} A_i + \lambda \left( \sigma_{out}^2 - \sum_{i=1}^{m} \sum_{j=1}^{n} \left( \frac{\partial S_{out}}{\partial p_{ij}} \right)^2 \frac{c_{ij}^2}{A_i} \right) \qquad [5]$$

wobei $\lambda$ der sogenannte Lagrangemultiplikator ist. Hat die untersuchte Funktion F unter der Nebenbedingung $\varphi$ einen relativen Extremwert im Punkt $A_0$, wobei der Punkt $A_0$ ein Vektor mit m Dimensionen ist, der alle Mindestflächenwerte $A_1$ bis Am enthält, so gelten die Gleichungen

$$\frac{\partial L}{\partial A_i}(A_0) = \frac{\partial f}{\partial A_i}(A_0) + \lambda \frac{\partial \varphi}{\partial A_i}(A_0) = 0 \quad \text{und} \tag{6}$$

$$\frac{\partial L}{\partial \lambda}(A_0) = \varphi(A_0) = 0 \tag{7}.$$

Setzt man die Gleichungen 4 und 1 in dieses Gleichungssystem ein, so folgt

$$\frac{\partial L}{\partial A_i}(A_0) = 1 + \lambda \sum_{j=1}^{n} \left( \frac{\partial S_{out}}{\partial p_{ij}} \right)^2 \frac{c_{ij}^2}{A_i^2} = 0 \tag{8}$$

und

$$\frac{\partial L}{\partial \lambda}(A_0) = \sigma_{out}^2 - \sum_{i=1}^{m} \sum_{j=1}^{n} \left( \frac{\partial S_{out}}{\partial p_{ij}} \right)^2 \frac{c_{ij}^2}{A_i} = 0 \tag{9}.$$

Dieses Gleichungssystem ist überraschenderweise analytisch lösbar auf Grund der in der Lagrangefunktion L vorkommenden Potenzen von $A_i$. Als Lösung dieses Gleichungssystems findet man daher die erfindungsgemäß verwendete Gleichung:

$$A_i = \frac{\sum_{i=1}^{m} \sqrt{\sum_{j=1}^{n} \frac{\partial S_{out}}{\partial p_{ij}}^2 c_{ij}^2}}{\sigma_{out}^2} \sqrt{\sum_{j=1}^{n} \frac{\partial S_{out}}{\partial p_{ij}}^2 c_{ij}^2} \tag{10}.$$

Berücksichtigt man, daß die Varianz einer Matching-sensitiven elektrischen Größe streng monoton mit abnehmender Fläche des Bauteils zunimmt, wie sich aus den Formeln zur Berechnung der Varianz verschiedener Parameter unmittelbar ergibt, so wird klar, daß es sich bei dem bestimmten Extremwert um ein Minimum handeln muß.

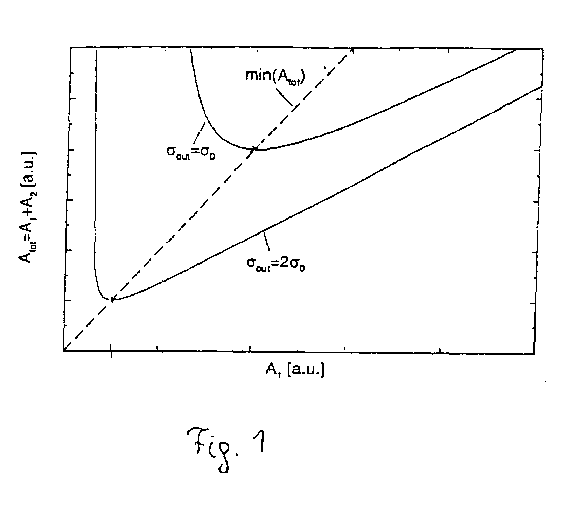

Figur 1 zeigt beispielhaft die Gesamtfläche eines Systems aus zwei Bauelementen unter Berücksichtigung von zwei Parametern. Die Kurven zeigen hierbei die Abhängigkeit $A_{tot}$ als Fläche des Gesamtsystems von $A_1$ als Fläche des ersten Bauelements im Hinblick auf eine vorgegebene Standardabweichung des Ausgabesignals. Es ist zu erkennen, daß eine hinsichtlich der Gesamtfläche optimale Flächenverteilung in diesem System existiert. Werden daher die Flächen der Einzelbauteile gemäß dem erfindungsgemäßen Verfahren bestimmt, ist die Gesamtfläche der Schaltung minimal. Für eine eindeutige Bestimmung der Flächen ist also ausschließlich die Kenntnis der Matching-Parameter und des Übertragungsverhaltens der Schaltung notwendig.

Falls pro Bauelement lediglich ein Parameter berücksichtigt werden soll, entfällt die Summation über den Index j, so daß sich die erfindungsgemäß eingesetzte Gleichung vereinfacht zu:

$$A_i = \frac{\sum_{i=1}^{m} \left| \dfrac{\partial S_{out}}{\partial p_i} \right| c_i}{\sigma_{out}^2} \left| \frac{\partial S_{ou}}{\partial p_i} \right| c_i \qquad [11]$$

In einer weiteren bevorzugten Ausführungsform der vorliegenden Erfindung werden nicht alle Bauelemente einer zu analysierenden Schaltung in die Berechnung mit einbezogen. In manchen Fällen führt nämlich eine konsequente Minimierung der Gesamtfläche der Schaltung über alle Bauelemente zu eventuell unerwünschten Flächenverteilungen innerhalb der Schaltung. So kann beispielsweise ein differentielles Paar eine überhöhte Eingangskapzität aufweisen. Als zusätzliche, weitere einfache Nebenbedingung kann deshalb die Fläche eines oder mehrerer Bauteile vorab festgelegt und mit den verbleibenden Parametern die Optimierung durchgeführt werden. Es gilt somit für den Gesamtfehler einer entsprechenden Schaltung:

$$\sigma_{out}^2 = \sum_{i=1}^{k} \sum_{j=1}^{n} \left( \frac{\partial S_{out}}{\partial p_{ij}} \right)^2 \frac{c_{ij}^2}{A_i} + \underbrace{\sum_{i=k+1}^{m} \sum_{j=1}^{n} \left( \frac{\partial S_{out}}{\partial p_{ij}} \right)^2 \frac{c_{ij}^2}{A_i}}_{durch\,Nebenbed.\,festgelegt} \qquad [12]$$

Hier wird unterschieden zwischen Bauelementen 1 bis k, deren Fläche optimiert werden soll, und Bauelementen k+1 bis m, deren Fläche durch die obige Nebenbedingung festgelegt ist, wobei m die Zahl aller Bauelemente in der Schaltung darstellt. Diese in ihrer Fläche festgelegten Bauteile leisten einen Grundbeitrag zur vorgegebenen Gesamtvarianz des Ausgangssignals der Schaltung, so daß für den Fehlerbetrag der zu optimierenden Bauteile eine Restvarianz definiert werden kann:

$$\hat{\sigma}_{out}^2 = \sigma_{out}^2 - \sum_{i=k+1}^{m} \sum_{j=1}^{n} \left( \frac{\partial S_{out}}{\partial p_{ij}} \right)^2 \frac{c_{ij}^2}{A_i} \qquad [13]$$

Ebenso müssen die Flächen der festgelegten Bauteile derart gewählt werden, daß gilt:

$$\sigma_{out}^2 > \sum_{i=k+1}^{m} \sum_{j=1}^{n} \left( \frac{\partial S_{out}}{\partial p_{ij}} \right)^2 \frac{c_{ij}^2}{A_i} \qquad [14]$$

Die Optimierung der restlichen Bauteilflächen führt dann zu einer modifizierten Kalkulationsvorschrift. Es ergibt sich die Gleichung:

$$A_i = \frac{\sum_{i=1}^{k} \sqrt{\sum_{j=1}^{n} \dfrac{\partial S_{out}}{\partial p_{ij}}^2 c_{ij}^2}}{\hat{\sigma}_{out}^2} \sqrt{\sum_{j=1}^{n} \frac{\partial S_{out}}{\partial p_{ij}}^2 c_{ij}^2} \qquad [15]$$

Sollen die optimalen Flächen rein analytisch bestimmt werden, so muß zunächst die Übertragungsfunktion der untersuchten Schaltung berechnet werden. Für große Schaltungen kann dies mathematisch sehr aufwendig werden oder nicht mehr geschlossen lösbar sein. Zur Optimierung komplexer Schaltungen muß deshalb hierarchisch vorgegangen werden. Betrachtet man die erfindungsgemäß minimierte Gesamtfläche der Schaltung:

$$A_{tot} = \sum_{i=1}^{m} A_i = \frac{1}{\sigma_{out}^2} \left( \sum_{i=1}^{m} \sqrt{\sum_{j=1}^{n} \left( \frac{\partial S_{out}}{\partial p_{ij}} \right)^2 c_{ij}^2} \right)^2 \qquad [16]$$

so kann man eine neue Matching-Konstante $c_{tot}$ definieren, die das Matching-Verhalten des gesamten Funktionsblocks beschreibt:

$$c_{tot} = \sum_{i=1}^{m} \sqrt{\sum_{j=1}^{n} \left( \frac{\partial S_{out}}{\partial p_{ij}} \right)^2 c_{ij}^2} \qquad [17]$$

Mit Hilfe dieser Konstanten kann erneut eine Beziehung zwischen der gesamten aktiven Fläche der Schaltung und den Matching-Anforderungen in der bekannten Form hergestellt werden:

$$\sigma_{out} = \frac{c_{tot}}{\sqrt{A_{tot}}} \qquad [18]$$

Es ist dadurch erfindungsgemäß möglich, eine komplexe Schaltung hierarchisch hinsichtlich ihrer Matching-Eigenschaften und ihres Gesamtflächenbedarfs zu analysieren. Das Matching-Verhalten der Gesamtschaltung kann auf die Eigenschaften kleinerer Funktionsblöcke zurückgeführt werden, was die Berechnung der Übertragungsfunktionen erleichtert und so in sehr großen Schaltungen eine Matching-Analyse erst ermöglicht. Ferner können mit Hilfe des erfindungsgemäßen Verfahrens Minima für die aktive Fläche der einzelnen Funktionsblöcke bestimmt werden, die als Grundlage für Gesamtflächenabschätzungen integrierter Schaltungen dienen können.

Auch bei der numerischen Flächenoptimierung mit Hilfe von Empfindlichkeitsanalysen kann hierarchisch vorgegangen werden. So lassen sich auch sehr komplexe Systeme konsequent flächenoptimal dimensionieren.

Im Folgenden sollen zur Veranschaulichung des erfindungsgemäßen Verfahrens zwei analytische Beispiele analoger Schaltungen vorgestellt werden.

Zur Berechnung der optimierten Bauteilflächen muß zunächst die Übertragungsfunktion bestimmt werden. Für Bauteile, die mehrere Arbeitsgebiete aufweisen, wie beispielsweise MOS-Transistoren, muß hierbei entschieden werden, welche mathematische Beschreibung ihrer Übertragsungsfunktion verwendet werden kann. Dies ergibt sich aus den erlaubten Betriebszuständen der Gesamtschaltung sowie aus Überlegungen hinsichtlich der Auswirkung der mismatch-bedingten Parametervariationen auf das Ausgangssignal. Ein Mismatch in der Schwellenspannung eines Transistors beispielsweise wirkt sich bei kleiner Gate-Spannung stärker auf den Ausgangsstrom aus als bei großer Gate-Spannung. Bei der analytischen Betrachtung kann durch eine worst-case-Betrachtung jedoch sichergestellt werden, daß die Schaltung in jedem erlaubten Betriebspunkt die Matching-Anforderungen, die der Optimierung zugrundegelegt werden, erfüllt. Im Falle einer numerischen Berechnung der Empfindlichkeiten (sensitivity analysis) wird diese Aufgabe durch das Schaltungsmodell und den Schaltungssimulator gelöst.

Beispiel 1

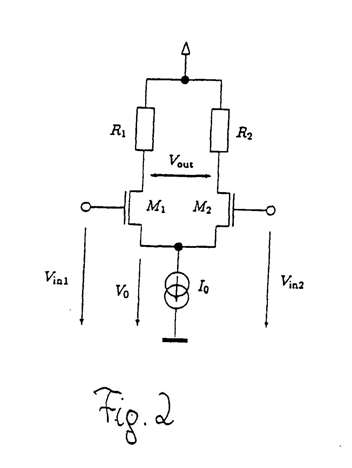

Im folgenden soll das erfindungsgemäße Verfahren der Gesamtflächenoptimierung auf ein differentielles Paar, wie es in Fig. 2 dargestellt ist, angewendet werden. Das Paar besteht aus zwei Transistoren $M_1$ und $M_2$ sowie zwei Widerständen $R_1$ und $R_2$, welche gegenüber einer Spannung Vo parallel geschaltet sind. Zwischen das differentielle Paar und die Erdung ist eine Stromquelle geschaltet, die den Strom Io liefert. Bei der Berechnung der Übertragungsfunktion wird davon ausgegangen, daß die Transistoren $M_1$ und $M_2$ im

Sättigungsgebiet arbeiten. Dann gilt für die Kanalströme $I_{ds1}$ und $I_{ds2}$:

$$I_{ds1} = \frac{\beta_1}{2}\left(V_{in1} - V_0 - V_{t1}^{\bullet}\right)^2 \qquad \text{und} \qquad [19]$$

$$I_{ds2} = \frac{\beta_2}{2}\left(V_{in2} - V_0 - V_{t2}^{\bullet}\right)^2 \qquad [20]$$

Die Randbedingungen für dieses System lauten:

$$I_0 = I_{ds1} + I_{ds2},$$

$$\beta = \beta_1 = \beta_2,$$

$$R = R_1 = R_2,$$

$$V_{in} = V_{in2} = V_{in1},$$

$$V_{out} = R_1^{\bullet} I_{ds1} - R_2^{\bullet} I_{ds2}$$

Die vom Mismatch betroffenen elektrischen Bauteilparameter sind in den obigen Gleichungen mit einem * versehen. Der Mismatch der Steilheiten $\beta_i$ wird nicht berücksichtigt, da von einem effektiven Gatespannungsmismatch ausgegangen wird.

Die Übertragungsfunktion kann unter Zuhilfenahme eines symbolischen Rechenprogramms wie der kommerziell erhältlichen Programme "Maple"™ oder "Mathematica"™ berechnet werden.

Nach Gleichung (10) ergibt sich für die optimierten Flächen:

$$A_{R_1} = A_{R_2} = \frac{R^2 I_0^{\frac{3}{2}}}{2\sigma_{out}^2}\left(2\sqrt{\beta}c_{n-MOS} + \sqrt{I_0}c_R\right)c_R \qquad [21]$$

$$A_{M_1} = A_{M_2} = \frac{R^2 \sqrt{\beta}I_0}{\sigma_{out}^2}\left(2\sqrt{\beta}c_{n-MOS} + \sqrt{I_0}c_R\right)c_{n-MOS} \qquad [22]$$

wobei $c_R$ und $c_n$-MOS die prozeßspezifischen Matching-Konstanten für Widerstände und n-MOS-Transistoren sind. Aus den AC- und DC-Spezifikationen der Schaltung ergeben sich $I_0$, $\beta$ und R, so daß bei geforderter Gesamtgenauigkeit $\sigma_{out}$ die Flächen aller Bauteile eindeutig bestimmt werden können.

Seien $I_0 = 100\ \mu A$, $\beta = 50\ \mu A/V$ und $R = 20k\Omega$. Die für einen Prozeß experimentell bestimmten Matching-Konstanten können für die Schwellenspannung von n-MOS-Transistoren $C_{n-MOS}^{pair}$ = 8.0 mVμm und für den Widerstandswert von Polysilizium-Widerständen $C_R^{pair}$ = 4.8 %μm sein.

Die gewünschte, nicht zu überschreitende Standardabweichung der Ausgangsspannung $\sigma_{out}$ kann beispielsweise 10mV betragen. Für die Mindestflächen der Bauteile ergeben sich dann folgende Werte:

$$A_{R_1} = A_{R_2} = 28.5 \ \mu m^2 \quad und \quad A_{M_1} = A_{M_2} = 6.71 \ \mu m^2.$$

Dies ist die bezüglich der aktiven Gesamtfläche optimale Flächenkonfiguration des differentiellen Paars unter den obigen Bedingungen.

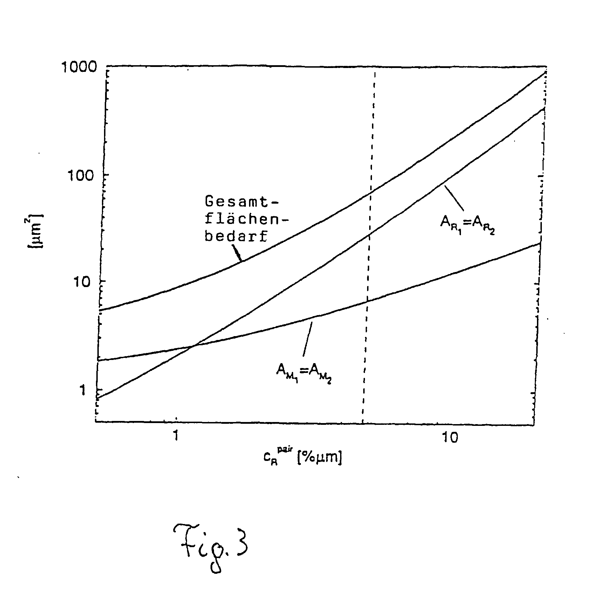

In Fig. 3 ist der Gesamtflächenbedarf der Schaltung in Abhängigkeit vom Wert der Matching-Konstanten der verwendeten Widerstände dargestellt. Die Werte für den DC-Arbeitspunkt und die Matching-Konstante für die Transistoren wurden aus obigem Beispiel übernommen. Es ist deutlich erkennbar, daß die optimale Flächenkonfiguration stark von der Matching-Konstanten der verwendeten Widerstände abhängt.

Beispiel 2

Die Genauigkeit von CMOS-Stromspiegeln hängt im wesentlichen vom Matching der strombestimmenden Transistoren in der Stromsenke, beziehungsweise der Stromquelle, ab. In diesem Beispiel soll am Beispiel einer Stromquelle mit hohem Ausgangswiderstand (regulated current mirror) eine Flächenoptimierung vorgenommen werden.

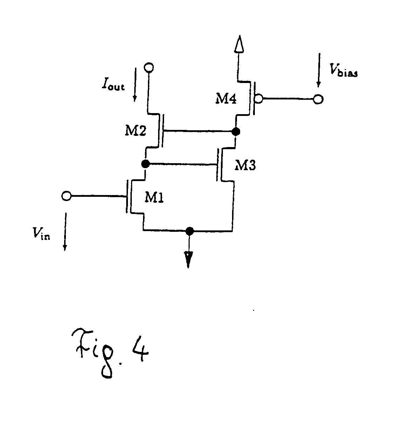

Fig. 4 zeigt das Schaltbild der im Beispiel verwendeten Stromquelle. Strombestimmender Transistor ist $M_1$, während $M_2$, $M_3$ und $M_4$ dazu dienen, das Source-Drain-Potential am Transistor $M_1$ konstant zu halten: $M_4$ stellt eine Konstantstromquelle dar, die den Biasstrom durch Transistor $M_3$ bestimmt. Über den Regeltransistor $M_2$ stellt sich deshalb am Gate von $M_3$ eine konstante Spannung ein.

Ein Stromspiegel besteht aus zwei entsprechend geschalteten derartigen Stromquellen. Seine Genauigkeit hängt von den Matching-Eigenschaften der Einzeltransistoren ab. Bei der Berechnung der Übertragungsfunktion wird davon ausgegangen, daß die Transistoren $M_3$ und $M_4$ in Sättigung sind, $M_1$ im linearen Gebiet betrieben wird und $M_2$ keinen Beitrag zu einer matching-bedingten Ungenauigkeit der Stromquelle liefert. Ein Fehler in der Schwellenspannung von $M_2$ wird durch die hohe Verstärkung des Regelkreises bestehend aus $M_2$, $M_3$ und $M_4$ weitgehend kompensiert. Die Ströme der Schaltung lassen sich wie folgt charakterisieren:

$$I_{out} = \beta_1 \left( V_{in} - V_{t1}^{\bullet} - \frac{V_{ds1}}{2} \right) V_{ds1} \qquad [23]$$

$$I_{ds3} = \frac{\beta_3}{2} \left( V_{gs3} - V_{t3}^{\bullet} \right)^2 \qquad [24]$$

und

$$I_{ds4} = \frac{\beta_4}{2} \left( V_{bias} - V_{t4}^{\bullet} \right)^2 \qquad [25]$$

Die vom Mismatch betroffenen elektrischen Bauteilparameter sind in diesen Gleichungen mit einem * versehen.

Die einzige Nebenbedingung zur Berechnung der Übertragungsfunktion lautet:

$$I_{ds3} = I_{ds4}.$$

Für die Beispielrechnung werden $V_{bias} = 0.80$ V, $V_{tn\text{-}MOS} = 0.45$

V, $v_{tp\text{-}MOS} = 0.50$ V, $V_{in} = 2.0$ V, $\beta_1 = 100 \dfrac{\mu A}{V}$, $\beta_3 = 1 \dfrac{mA}{V}$ und $\beta_4 = 200 \dfrac{\mu A}{V}$ eingesetzt. Die Abweichung im Ausgangsstrom zweier benachbarter Stromquellen soll dabei kleiner als $\sigma_{rel}$ 0.002 sein. Dann ergeben sich bei einer prozeßbedingten Matching-Konstanten von $c_{n\text{-}MOS}^{pair} = c_{p\text{-}MOS}^{pair} = 8.0$ mV$\mu$m für die Mindestflächen der Transistoren folgende Werte:

$$A_{M_1} = 17.2 \ \mu m^2, \ A_{M_3} = 28.4 \ \mu m^2 \ \text{und} \ A_{M_4} = 12.7 \ \mu m^2.$$

Die Berechnung bestätigt, daß neben der Fläche des strombestimmenden Transistors $M_1$ auch die Transistoren $M_3$ und $M_4$ wesentliche Beiträge zum Gesamtmatching zweier derartiger Stromquellen liefern.

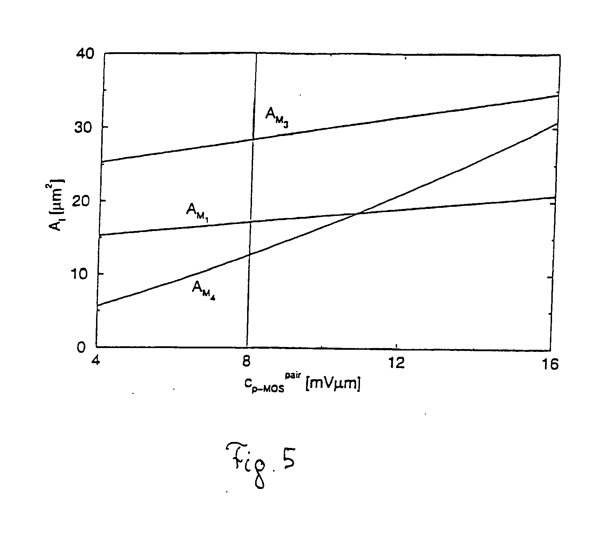

In Fig. 5 sind die optimalen Flächen der Transistoren für verschiedene Matching-Konstanten $c_{p\text{-}MOS}^{pair}$ aufgetragen. Hier ist deutlich die unterschiedliche Gewichtung der Einzeltransistoren zu erkennen.

Die Berechnung der Übertragungsfunktion der zu optimierenden Schaltung erweist sich besonders bei größeren Funktionsblöcken als aufwendig. In vielen Fällen kann das Ergebnis nicht mehr geschlossen angegeben werden.

Die Berechnung der Übertragungsfunktion ist nicht notwendig, wenn eine Empfindlichkeitsanalyse mit Hilfe des Schaltungssimulators durchgeführt wird. Viele Simulationsprogramme (beispielsweise SPICE) bieten die Option einer sensitivity analysis, bei der die Empfindlichkeiten der elektrischen Modellparameter auf die angegebenen Ausgangssignale berechnet und ausgegeben werden können.

Die erhaltenen Daten repräsentieren direkt die Ableitungen $\partial S_{out}/\partial p_{ij}$ der Übertragungsfunktion nach den statistisch abweichenden Parametern im zuvor beschriebenen Formalismus. Auf diese Weise können bei Kenntnis der Matching-Konstanten einfach optimale Flächenverteilungen ohne explizite Berechnung der Übertragungsfunktion erhalten werden.

Das erfindungsgemäße Verfahren erlaubt es, mismatch-sensitive Schaltungen analytisch, also ohne die Durchführung von rechen- und zeitintensiven Monte-Carlo-Simulationen zu dimensionieren. Die Mindestflächen der Einzelbauteile können derart bestimmt werden, daß entweder die Gesamtfläche minimiert oder andere flächenabhängige Schaltungseigenschaften optimiert werden. Die Ergebnisse stellen zudem, im Gegensatz zur Monte-Carlo-Simulation, nicht einen mit statistischen Fehlern behafteten günstigsten Fall, sondern das mathematisch gefundene eindeutige absolute Minimum dar. Die Möglichkeit der hierarchischen Berechnung erlaubt es, auch sehr komplexe Schaltungen konsequent zu optimieren und Gesamtflächenabschätzungen vorzunehmen, wenn die Bauteilgröße im wesentlichen durch Mismatch-Randbedingungen festgelegt wird.

In der Entwicklungsphase analoger Schaltungen bieten sich Vorteile, da alleine mit Kenntnis der Übertragungsfunktion des Schaltungsblocks und den Matching-Parametern des jeweiligen Prozesses typische Bauteildimensionen und die Flächenverteilung innerhalb einer Schaltung berechnet werden können. Die gleichzeitige Berücksichtigung von Matching- und Rausch-Gesichtspunkten bei der Optimierung ist ebenso möglich.

Unterstützt das im design flow verwendete Simulationsprogramm Empfindlichkeitsanalysen, so können die optimalen Flächen einfach numerisch aus den simulierten Daten errechnet werden. Da auch andere Schaltungseigenschaften, beispielsweise auf Grund veränderter Kapazitäten, von den Bauteilflächen abhängen, müssen die erhaltenen Flächen in das Schematic, die Netzliste oder das Layout zurückgeschrieben und eine neue Simulation vorgenommen werden. Dies kann auch automatisiert werden.

**Patentansprüche**

1. Verfahren zur Flächenoptimierung von Bauelementen in einer integrierten Schaltung mit m Bauelementen, ausgeführt in einer Datenverarbeitungsanlage, mit folgenden Schritten:

- Festlegen eines Ausgangssignals $S_{out}$ der Schaltung;
- Festlegen einer vorgegebenen Standardabweichung $\sigma_{out}$ des Ausgangssignals $S_{out}$ der Schaltung;
- Bestimmen der Mindestflächen $A_i$ für $m \geq 2$ Bauelemente der Schaltung durch die folgende Gleichung:

$$A_i = \frac{\sum_{i=1}^{m} \sqrt{\sum_{j=1}^{n} \frac{\partial S_{out}^2}{\partial p_{ij}} c^2 ij}}{\sigma^2 out} \sqrt{\sum_{j=1}^{n} \frac{\partial S_{out}^2}{\partial p_{ij}} c^2 ij}$$

wobei $c_{ij}$ eine vorbestimmte Matching Konstante für den j-ten elektrischen Parameter von n elektrischen Parametern mit $1 \leq j \leq n$ des i-ten Bauelements aus m Bauelementen mit $2 \leq in\ m$ ist, wobei die Matching Konstante $c_{ij}$ für den j-ten elektrischen Parameter $p_{ij}$ des i-ten Bauelements die gemessene Variation des j-ten elektrischen Parameters bei paarweisem Vorkommen des i-ten Bauelements beschreibt; und $\partial S_{out}/\partial p_{ij}$ die partielle Ableitung des Ausgangssignal $S_{out}$ des j-ten elektrischen Parameter $p_{ij}$ des i-ten Bauelements ist.

2. Verfahren nach Anspruch 1,
   **dadurch gekennzeichnet, daß**
   es in einem Gerät zur Erzeugung und/oder Planung von Belichtungsmasken für integrierte Halbleiterstrukturen durchgeführt wird.

3. Verfahren nach Anspruch 1 oder 2,
   **dadurch gekennzeichnet, daß**
   es den weiteren Schritt aufweist:

   - Synthetisieren eines Schaltplanlayouts anhand der Flächendaten der Bauelemente.

4. Verfahren nach einem der Ansprüche 1 bis 3,
   **dadurch gekennzeichnet, daß**
   ein elektrischer Parameter die Schwellenspannung von Transistoren ist.

5. Verfahren nach einem der Ansprüche 1 bis 4,
   **dadurch gekennzeichnet, daß**
   ein elektrischer Parameter der Flächenwiderstandswert von integrierten Widerständen ist.

6. Verfahren nach einem der Ansprüche 1 bis 5,
   **dadurch gekennzeichnet, daß**
   mit mindestens einem elektrischen Parameter das 1/f-Rauschen eines MOS-Transistors repräsentiert ist.

7. Verfahren nach einem der Ansprüche 1 bis 6,
   **dadurch gekennzeichnet, daß** mit mindestens einem elektrischen Parameter das 1/f-Rauschen eines integrierten Widerstands repräsentiert ist.

8. Verfahren nach einem der Ansprüche 1 bis 7,
   **dadurch gekennzeichnet, daß**
   die Parameter $p_{ij}$ voneinander statistisch unabhängig sind.

9. Verfahren nach einem der Ansprüche 1 bis 8,
   **dadurch gekennzeichnet, daß**
   zumindest ein Bauelement wiederum eine Schaltung ist, deren Matching-Konstante $c_{tot}$ sich ergibt als:

$$c_{tot} = \sum_{i=1}^{m} \sqrt{\sum_{j=1}^{n} \left(\frac{\partial S_{out}}{\partial p_{ij}}\right)^2 c_{ij}^2} \; .$$

**10.** Verfahren nach einem der Ansprüche 1 bis 9,
**dadurch gekennzeichnet, daß**
nur je ein Parameter für jedes Bauteil berücksichtigt wird, wobei die Mindestfläche $A_i$ eines i-ten Bauelementes der Schaltung nach folgender vereinfachter Gleichung bestimmt wird:

$$A_i = \frac{\sum_{i=1}^{m} \left|\frac{\partial S_{out}}{\partial p_i}\right| c_i}{\sigma_{out}^2} \left|\frac{\partial S_{out}}{\partial p_i}\right| c_i \; .$$

**11.** Verfahren nach einem der Ansprüche 1 bis 10, **dadurch gekennzeichnet, daß** zumindest eines der Bauelemente der Schaltung eine vorgegebene Fläche A aufweist und daher bei der Bestimmung der Mindestflächen $A_i$ der übrigen Bauelemente der Schaltung nicht einbezogen wird, wobei die Mindestfläche $A_i$ eines i-ten Bauelementes der Schaltung nach folgender Gleichung bestimmt wird:

$$A_i = \frac{\sum_{i=1}^{k} \sqrt{\sum_{j=1}^{n} \frac{\partial S_{out}^2}{\partial p_{ij}} c_{ij}^2}}{\hat{\sigma}_{out}^2} \sqrt{\sum_{j=1}^{n} \frac{\partial S_{out}^2}{\partial p_{ij}} c_{ij}^2}$$

wobei für $\hat{\sigma}_{out}^2$ gilt:

$$\hat{\sigma}_{out}^2 = \sigma_{out}^2 - \sum_{i=k+1}^{m} \sum_{j=1}^{n} \left(\frac{\partial S_{out}}{\partial p_{ij}}\right)^2 \frac{c_{ij}^2}{A_i} \; .$$

**12.** Datenverarbeitungsanlage zur computer-implementierten Flächenoptimierung von Bauelementen in einer integrierten Schaltung mit m Bauelementen, eingerichtet zum Durchführen folgender Schritte:

- Festlegen eines Ausgangssignals $S_{out}$ der Schaltung;
- Festlegen einer vorgegebenen Standardabweichung $\sigma_{out}$ des Ausgangssignals $S_{out}$ der Schaltung;
- Bestimmen der Mindestflächen $A_i$ für $m \geq 2$ Bauelemente der Schaltung durch die folgender Gleichung:

$$Ai = \frac{\sum_{i=1}^{m} \sqrt{\sum_{j=1}^{n} \frac{\partial S out^2}{\partial pij} c^2 ij}}{\sigma^2 out} \sqrt{\sum_{j=1}^{n} \frac{\partial S out^2}{\partial pij} c^2 ij},$$

wobei $c_{ij}$ eine vorbestimmte Matching Konstante für den j-ten elektrischen Parameter von n elektrischen Parametern mit $1 \le j \le n$ des i-ten Bauelements aus m Bauelementen mit $2 \le i \le m$ ist, wobei die Matching Konstante $c_{ij}$ für den j-ten elektrischen Parameter $p_{ij}$ des i-ten Bauelements die gemessene Variation des j-ten elektrischen Parameters bei paarweisem Vorkommen des i-ten Bauelements beschreibt; und $\partial S_{out}/\partial p_{ij}$ die partielle Ableitung des Ausgangssignal $S_{out}$ des j-ten elektrischen Parameter $p_{ij}$ des i-ten Bauelements ist.

13. Verfahren nach einem der Ansprüche 1 bis 11, **gekennzeichnet durch** eine Bestimmung oder Berechnung der Übertragungsfunktion der Schaltung.

**Claims**

1. Method for area optimization of components in an integrated circuit with m components, executed in a data processing system with following steps:

   specifying an output signal $S_{out}$ of the circuit;
   specifying a predetermined standard deviation $\sigma_{out}$ of the output signal $S_{out}$ of the circuit;
   determining the minimum area $A_i$ for $m \ge 2$ components of the circuit by the following equation:

$$A_i = \frac{\sum_{i=1}^{m} \sqrt{\sum_{j=1}^{n} \frac{\partial S_{out}^2}{\partial p_{ij}} c^2_{ij}}}{\sigma^2_{out}} \sqrt{\sum_{j=1}^{n} \frac{\partial S_{out}^2}{\partial p_{ij}} c^2_{ij}}$$

   wherein $c_{ij}$ is a predetermined matching constant for the jth electrical parameter of n electrical parameters with $1 \le j \le n$ of the ith component of m components with $2 \le i \le m$, wherein the matching constant $c_{ij}$ for the jth electrical parameter $p_{ij}$ of the ith component describes the measured variation of the jth electrical parameter of the ith electrical component with pairwise occurrence; and $\partial S_{out}/\partial p_{ij}$ is the partial derivative of the output signal $S_{out}$ of the jth electrical parameter $p_{ij}$ of the ith component.

2. Method of claim 1, **characterized in that** it is carried out in a device for the generation and/or planning of exposure masks for integrated semiconductor structures.

3. Method of claim 1 or 2, **characterized in that** it comprises the further step:

   synthesizing of a circuit diagram layout by means of the area data of the components.

4. Method of any of the claims 1 to 3, **characterized in that** an electrical parameter is the threshold voltage of transistors.

5. Method of any of the claims 1 to 4, **characterized in that** an electrical parameter is the sheet resistance value of integrated resistors.

6. Method of any of the claims 1 to 5, **characterized in that** the 1/f-noise of a MOS-transistor is represented by at least one electrical parameter.

7. Method of any of the claims 1 to 6, **characterized in that** the 1/f-noise of an integrated resistor is represented by at least one electrical parameter.

8. Method of any of the claims 1 to 7, **characterized in that** the parameters $p_{ij}$ are statistically independent of each other.

9. Method of any of the claims 1 to 8, **characterized in that** at least one component is in turn a circuit, whose matching constant $c_{tot}$ is obtained by

$$c_{tot} = \sum_{i=1}^{m} \sqrt{\sum_{j=1}^{n} \left( \frac{\partial S_{out}}{\partial p_{ij}} \right)^2 c_{ij}^2} \; .$$

10. Method of any of the claims 1 to 9, **characterized in that** only one parameter for each component is considered, wherein the minimum area $A_i$ of an ith component of the circuit is determined according to the following simplified equation:

$$A_i = \frac{\sum_{i=1}^{m} \left| \frac{\partial S_{out}}{\partial p_i} \right| c_i}{\sigma_{out}^2} \left| \frac{\partial S_{out}}{\partial p_i} \right| c_i \; .$$

11. Method of any of the claims 1 to 10, **characterized in that** at least one of the components of the circuit has a given area A and therefore is not considered while determining the minimal area $A_i$ of the remaining components of the circuit, wherein the minimal area $A_i$ of an ith component of the circuit is determined according to the following equation:

$$A_i = \frac{\sum_{i=1}^{k} \sqrt{\sum_{j=1}^{n} \frac{\partial S_{out}}{\partial p_{ij}}^2 c^2{}_{ij}}}{\hat{\sigma}_{out}^2} \sqrt{\sum_{j=1}^{n} \frac{\partial S_{out}}{\partial p_{ij}}^2 c^2{}_{ij}} \; ,$$

wherein the following applies to $\hat{\sigma}_{out}^2$ :

$$\hat{\sigma}_{out}^2 = \sigma_{out}^2 - \sum_{i=k+1}^{m} \sum_{j=1}^{n} \left( \frac{\partial S_{out}}{\partial p_{ij}} \right)^2 \frac{c_{ij}^2}{A_i} \; .$$

12. Data processing system for computer-implemented area optimization of components in an integrated circuit with m components, configured to perform following steps:

   specifying an output signal $S_{out}$ of the circuit;
   specifying a predetermined standard deviation $\sigma_{out}$ of the output signal $S_{out}$ of the circuit;
   determining the minimum area $A_i$ for $m \geq 2$ components of the circuit by the following equation:

$$A_i = \frac{\sum_{i=1}^{m}\sqrt{\sum_{j=1}^{n}\frac{\partial S_{out}^{2}}{\partial p_{ij}}c^{2}{}_{ij}}}{\hat{\sigma}^{2}{}_{out}}\sqrt{\sum_{j=1}^{n}\frac{\partial S_{out}^{2}}{\partial p_{ij}}c^{2}{}_{ij}}$$

wherein $c_{ij}$ is a predetermined matching constant for the jth electrical parameter of n electrical parameters with $1 \leq j \leq n$ of the ith component of m components with $2 \leq 1 \leq m$, wherein the matching constant $c_{ij}$ for the jth electrical parameter $p_{ij}$ of the ith component describes the measured variation of the jth electrical parameter of the ith electrical component with pairwise occurrence; and $\partial S_{out}/\partial p_{ij}$ is the partial derivative of the output signal $S_{out}$ of the jth electrical parameter $p_{ij}$ of the ith component.

**13.** Method of any of the claims 1 to 11, **characterized by** a determination or calculation of the transfer function of the circuit.

## Revendications

**1.** Procédé d'optimisation de surface de composants d'un circuit intégré ayant m composants, réalisé dans une installation de traitement de données, comprenant les stades, dans lesquels :

- on fixe un signal $S_{out}$ de sortie du circuit ;
- on fixe un écart-type $\sigma_{out}$ prescrit du signal $S_{out}$ de sortie du circuit ;
- on détermine les surfaces $A_i$ minimum pour $m \geq 2$ composants du circuit pour l'équation suivante :

$$A_i = \frac{\sum_{i=1}^{m}\sqrt{\sum_{j=1}^{n}\frac{\partial S_{out}^{2}}{\partial p_{ij}}c^{2}{}_{ij}}}{\sigma^{2}{}_{out}}\sqrt{\sum_{j=1}^{n}\frac{\partial S_{out}^{2}}{\partial p_{ij}}c^{2}{}_{ij}}$$

dans laquelle $c_{ij}$ est une constante déterminée à l'avance de couplage pour le j-ème paramètre électrique de n paramètres électriques avec $1 \leq j \leq n$ du i-ème composant parmi les m composants avec $2 \leq i \leq m$, la constante $c_{ij}$ de couplage pour le j-ème paramètre $p_{ij}$ du i-ème composant décrivant la variation mesurée du j-ème paramètre électrique lors de l'appariement du i-ème composant ; et $\partial S_{out}/\partial p_{ij}$ est la dérivée partielle du signal $S_{out}$ de sortie du j-ème paramètre $p_{ij}$ électrique du i-ème composant.

**2.** Procédé suivant la revendication 1,
**caractérisé en ce que**
il est effectué dans un appareil de production et/ou de conception de masques d'éclairage pour des structures intégrées à semiconducteurs.

**3.** Procédé suivant la revendication 1 ou 2,
**caractérisé en ce que**
il comporte le stade supplémentaire, dans lequel :

- on synthétise une implantation de plan de connexion au moyen des données de surface des composants.

**4.** Procédé suivant l'une des revendications 1 à 3, **caractérisé en ce que**
un paramètre électrique est la tension de seuil de transistor.

**5.** Procédé suivant l'une des revendications 1 à 4, **caractérisé en ce que**
un paramètre électrique est la valeur de résistance de surface de résistances intégrées.

6. Procédé suivant l'une des revendications 1 à 5, **caractérisé en ce que**
le bruit 1/f d'un transistor MOS est représenté par au moins un paramètre électrique.

7. Procédé suivant l'une des revendications 1 à 6, **caractérisé en ce que**
le bruit 1/f d'une résistance intégrée est représenté par au moins un paramètre électrique.

8. Procédé suivant l'une des revendications 1 à 7, **caractérisé en ce que**
les paramètres $p_{ij}$ sont indépendants statistiquement les uns des autres.

9. Procédé suivant l'une des revendications 1 à 8, **caractérisé en ce que**
au moins un composant est à nouveau un circuit dont la constante $c_{tot}$ de couplage est obtenue par :

$$c_{tot} = \sum_{i=1}^{m} \sqrt{\sum_{j=1}^{n}\left(\frac{\partial S_{out}}{\partial p_{ij}}\right)^2 c_{ij}^2} \ .$$

10. Procédé suivant l'une des revendications 1 à 9, **caractérisé en ce que**
l'on ne tient compte pour chaque composant que d'un paramètre, la surface $A_i$ minimum d'un i-ème composant du circuit étant déterminée par l'équation simplifiée suivants :

$$A_i = \frac{\sum_{i=1}^{m}\left|\frac{\partial S_{out}}{\partial p_i}\right| c_i}{\sigma_{out}^2} \left|\frac{\partial S_{out}}{\partial p_i}\right| c_i \ .$$

11. Procédé suivant l'une des revendications 1 à 10, **caractérisé en ce qu'**au moins l'un des composants du circuit a une surface A prescrite et donc n'est pas incluse lors de la détermination des surfaces $A_i$ minimum des autres composants du circuit, la surface $A_i$ minimum d'un i-ème composant du circuit étant déterminée par l'équation suivante :

$$A_i = \frac{\sum_{i=1}^{k}\sqrt{\sum_{j=1}^{n}\frac{\partial S_{out}^2}{\partial p_{ij}}c^2{}_{ij}}}{\hat{\sigma}_{out}^2} \sqrt{\sum_{j=1}^{n}\frac{\partial S_{out}^2}{\partial p_{ij}}c^2{}_{ij}} \ ,$$

dans laquelle on a pour $\hat{\sigma}_{out}^2$ :

$$\hat{\sigma}_{out}^2 = \sigma_{out}^2 - \sum_{i=k+1}^{m}\sum_{j=1}^{n}\left(\frac{\partial S_{out}}{\partial p_{ij}}\right)^2 \frac{c_{ij}^2}{A_i} \ .$$

**12.** Installation de traitement de données pour l'optimisation de surfaces mises en oeuvre par ordinateur de composants d'un circuit intégré ayant m composants, conçue pour effectuer les stades suivantes :

- on fixe un signal $S_{out}$ de sortie du circuit ;
- on fixe un écart-type $\sigma_{out}$ prescrit du signal $S_{out}$ de sortie du circuit ;
- on détermine les surfaces $A_i$ minimum pour $m \geq 2$ composants du circuit pour l'équation suivants :

$$A_i = \frac{\sum_{i=1}^{m} \sqrt{\sum_{j=1}^{n} \frac{\partial S_{out}^2}{\partial p_{ij}} c^2_{ij}}}{\hat{\sigma}_{out}^2} \sqrt{\sum_{j=1}^{n} \frac{\partial S_{out}^2}{\partial p_{ij}} c^2_{ij}}$$

dans laquelle $c_{ij}$ est une constante déterminée à l'avance de couplage pour le j-ème paramètre électrique de n paramètres électriques avec $1 \leq j \leq n$ du i-ème composant parmi les m composants avec $2 \leq i \leq m$, la constante $c_{ij}$ de couplage pour le j-ème paramètre $p_{ij}$ du i-ème composant décrivant la variation mesurée du j-ème paramètre électrique lors de l'appariement du i-ème composant ; et $\partial S_{out}/\partial p_{ij}$ est la dérivée partielle du signal $S_{out}$ de sortie du j-ème paramètre $p_{ij}$ électrique du i-ème composant.

**13.** Procédé suivant l'une des revendications 1 à 11, **caractérisé par** une détermination ou un calcul de la fonction de transfert du circuit.

Fig. 1

Fig. 2

Fig. 3

Fig. 4

Fig. 5

## IN DER BESCHREIBUNG AUFGEFÜHRTE DOKUMENTE

**In der Beschreibung aufgeführte Nicht-Patentliteratur**

- **H. Su et al.** Statistical constrained optimization of analog MOS circuits using empirical performance models. *IEEE International Symposium on Circuits and Systems,* 1994, vol. 1, 133-136

- **C.J. Abel et al.** Characterization of transistor mismatch for statistical CAD of submicron CMOS analog circuits. *IEEE International Symposium on Circuits and Systems,* 1993, 1401-1404
- **M.J.M. Pelgrom.** Matching properties of MOS transistors. *IEEE Journal of Solid-State Circuits,* 1989, vol. 24 (5), 1433-1440